# EUROPEAN PATENT APPLICATION

(11) **EP 1 622 038 A2**
(43) Date of publication of application: **01.02.2006**
(21) Application number: 05254321.2
(22) Date of filing: 11.07.2005
(51) Int. Cl.: G06F 13/40

(54) **Printed circuit board having an integrated slot mounted thereon**

(30) Priority: 14.07.2004 KR 2004054807
(71) Applicant: SAMSUNG ELECTRONICS CO., LTD., Suwon-si, Gyeonggi-do (KR)
(72) Inventor: Kim, Hoe-young, Woncheon-dong, Yeongtong-gu, Gyeonggi-do (KR)
(74) Representative: Robinson, Ian Michael

(57) **Abstract**

A printed circuit board (300,500,600) having an integrated slot (310,510,610) mounted thereon is provided. In the printed circuit board (300,500,600) having a central processing unit (320) and a device controlled by the central processing unit (320), the printed circuit board (300,500,600) comprises an integrated slot (310,510,610) which allows a plurality of boards (330,530,630) to perform communication functions by being selectively combined with the boards (330,530,630). The integrated slot (310,510,610) is configured such that the boards (330,530,630) are vertically combined with the printed circuit board (300,500,600).

## Description

The present invention relates to a printed circuit board. More particularly, the present invention relates to a method for designing the structure of a connector or a slot mounted on a printed circuit board to provide space required for a communication board and an interface on the printed circuit board through the connector or the slot.

In general, a main board of a personal computer (PC) such as an IBM PC has grooves, called extension slots, into which extension boards for peripheral devices are inserted, so that a central processing unit such as a microcomputer can extend peripheral devices. Most PCs have between 3 and 8 extension slots.

However, a small portable computer, such as a laptop or palmtop computer, or a set-top box provides a personal computer memory card international association (PCMCIA) slot as an extension slot into which a PC card is inserted.

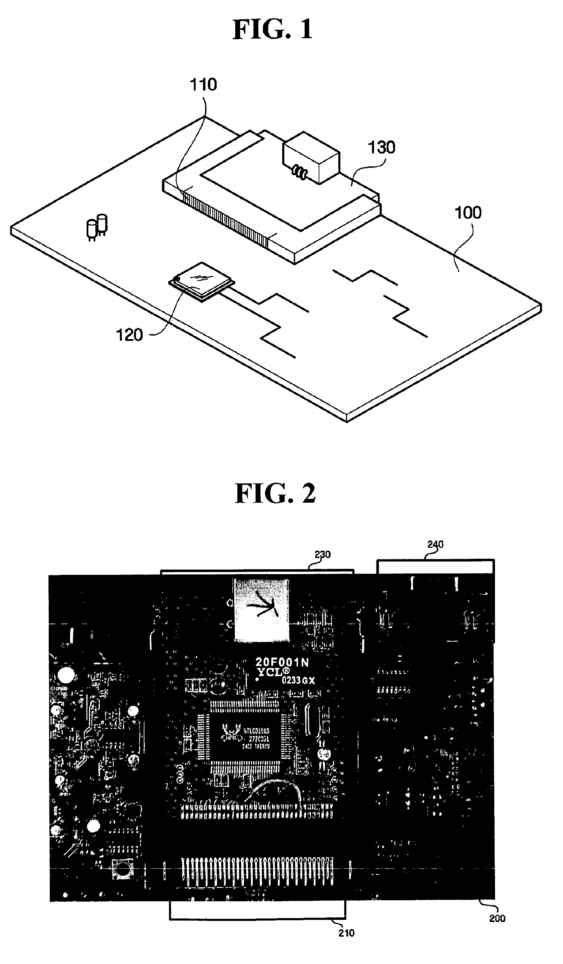

Figure 1 illustrates a schematic structure of a printed circuit board 100 on which a PCMCIA slot combined with a PCMCIA card is mounted in a conventional manner.

Referring to Figure 1, the printed circuit board 100 includes a central processing unit 120, and a PCMCIA slot 110 is attached to the printed circuit board 100 to allow a PC card 130 like a LAN card to be inserted horizontally with respect to the printed circuit board 100.

Figure 2 illustrates a conventional exemplary embodiment of a printed circuit board 200 on which a PCMCIA slot combined with a PCMCIA card is mounted.

Referring to Figure 2, a PCMCIA slot 210 is attached to the printed circuit board 200, and a LAN card 230 is inserted into the PCMCIA slot 210. Also, a parallel communication port 240 for implementing a function such as software downloading is attached to the printed circuit board 200 while occupying a predetermined portion of the printed circuit board 200.

As shown in Figures 1 and 2, pins forming PCMCIA slots are generally arranged in a horizontal direction with respect to a main board. Thus, when a PC card is inserted into the PCMCIA slot, it is inserted horizontally with respect to the main board. In addition, to perform a function such as software downloading, a separate communication port needs to be prepared. Accordingly, in a system where a size of components is a main consideration, a space of a printed circuit board, which is occupied by a PCMCIA slot and a separate communication port, also becomes an important issue. Moreover, the bigger the product associated with a printed circuit board becomes, the more expensive the product becomes. Further, in a case where a PCMCIA slot is used, a pin may bend during insertion or detachment of a PC card, resulting in a malfunction.

In light of the foregoing, there is a need for a new structure that addresses the main considerations of size and space-saving features.

According to the present invention there is provided an apparatus and method as set forth in the appended claims. Preferred features of the invention will be apparent from the dependent claims, and the description which follows.

The present invention provides a printed circuit board having an integrated slot mounted thereon to save space on the printed circuit board by mounting the integrated slot on the printed circuit board differently from conventional mounting methods, in which the integrated slot allows a plurality of boards to perform communication functions by being selectively combined with the boards.

The above stated object as well as other objects, features and advantages, of the present invention will become clear to those skilled in the art upon review of the following description.

According to an aspect of the present invention, there is provided a printed circuit board comprising a central processing unit and a device controlled by the central processing unit, the printed circuit board comprising an integrated slot which allows a plurality of boards to perform communication functions by the integrated slot being selectively combined with the boards, and where the integrated slot is configured such that the boards are vertically combined with the printed circuit board.

Preferably, the integrated slot is a PCMCIA slot.

In a second aspect of the present invention there is provided a system comprising: a printed circuit board comprising a central processing unit and a device controlled by the central processing unit, the printed circuit board comprising an integrated slot; and a board arranged to be selectively combined with the integrated slot to perform a communication function; characterised in that: the integrated slot is configured such that the board is vertically combined with the printed circuit board.

Preferably, the system is a lap-top computer.

For a better understanding of the invention, and to show how embodiments of the same may be carried into effect, reference will now be made, by way of example, to the accompanying diagrammatic drawings in which:
Figure 1 illustrates a schematic structure of a printed circuit board on which a personal computer memory card international association (PCMCIA) slot combined with a PCMCIA card is mounted in a conventional manner;
Figure 2 illustrates a conventional exemplary embodiment of the printed circuit board on which a PCMCIA slot combined with a PCMCIA card is mounted;
Figure 3 illustrates a schematic structure of a printed circuit board on which an integrated slot is mounted according to an embodiment of the present invention;
Figure 4 is a cross-sectional view of an integrated slot according to an embodiment of the present invention;
Figure 5A illustrates a local area network (LAN) card according to an embodiment of the present invention;
Figure 5B illustrates a printed circuit board on which an integrated slot combined with the LAN card is mounted according to an embodiment of the present invention;
Figure 5C is a block diagram of the LAN card of Figure 5A;
Figure 6A illustrates a parallel communication card according to an embodiment of the present invention;
Figure 6B illustrates a printed circuit board on which an integrated slot combined with the parallel communication card is mounted according to an embodiment of the present invention; and
Figure 6C is a block diagram of the parallel communication card of Figure 6A.

Throughout the drawings, the same or similar elements are denoted by the same reference numerals.

Advantages and features of the present invention and methods of accomplishing the same may be understood more readily by reference to the following detailed description of embodiments and the accompanying drawings. The present invention may, however, be embodied in many different forms and should not be construed as being limited to the embodiments set forth herein. Rather, these embodiments are provided so as examples.

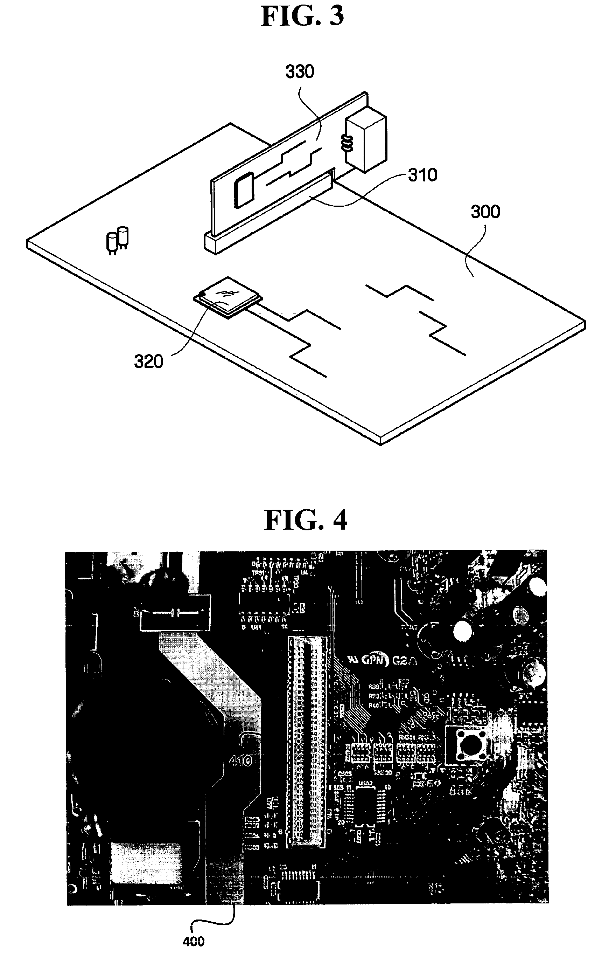

Figure 3 illustrates a schematic structure of a printed circuit board on which an integrated slot is mounted according to an embodiment of the present invention.

A printed circuit board 300 comprises a central processing unit 320. An integrated slot 310 is attached to the printed circuit board 300 to allow a PC card 330 such as a local area network (LAN) card to be inserted vertically or perpendicularly or at an angle with respect to the printed circuit board 300.

The integrated slot 310 has a plurality of information transmission lines mounted therein. The PC card 330 can be combined with the integrated slot 310 using information transmission lines whose number is less than or equal to the number of the information transmission lines included in the integrated slot 310. Preferably, the number of information transmission lines used is 69.

According to an embodiment of the present invention, a separate slot for implementing a function like software downloading is not required, but instead the function of the separate slot may be implemented through the integrated slot 310. For example, for software downloading, a board comprising a parallel communication port may be inserted into the integrated slot 310.

As such, the integrated slot 310 is attached to the printed circuit board 300 such that various boards are vertically combined with the printed circuit board 300, and the integrated slot 310 supports boards that implement various communication functions. Thus, it is possible to reduce a space occupied by the integrated slot 310 on the printed circuit board 300 and the cost required for manufacturing the printed circuit board 300.

Figure 4 is a cross-sectional view of an integrated slot 410 according to an embodiment of the present invention.

Referring to Figure 4, the integrated slot 410 is vertically combined with a printed circuit board 400.

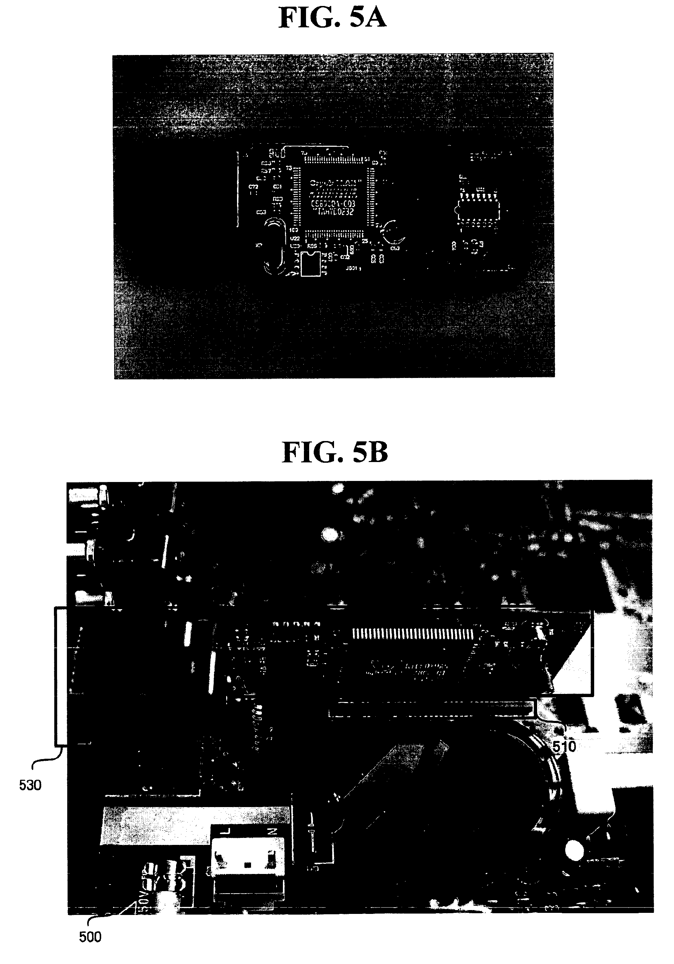

Figure 5A illustrates a LAN card according to an embodiment of the present invention, and Figure 5B illustrates a printed circuit board on which an integrated slot combined with the LAN card is mounted according to an embodiment of the present invention.

An integrated slot 510 is attached to a printed circuit board 500, and a LAN card 530 is combined with the printed circuit board 500 in a vertical direction.

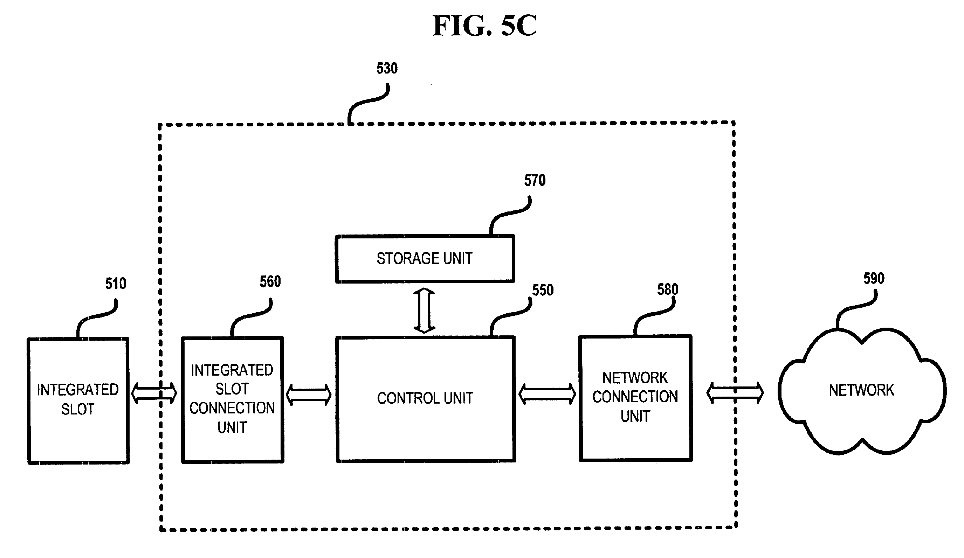

Figure 5C is a block diagram of the LAN card 530 of Figure 5A. The LAN card 530 according to an embodiment of the present invention comprises a control unit 550, an integrated slot connection unit 560, a storage unit 570, and a network connection unit 580. The integrated slot connection unit 560 is combined with the integrated circuit 510 according to an embodiment of the present invention. The network connection unit 580 is connected to a network transmission medium or interface. For example, in the case of Ethernet, an RJ-45 jack may be used as the network connection unit 580 and connected to a coaxial cable that is a network transmission medium. The network transmission medium is not necessarily a wired medium, but instead may be a wireless medium. If the network transmission medium is a wireless medium, the LAN card 530 comprises a wireless transceiving module. The storage unit 570 stores a medium access control address (MAC) address and may be preferably an electrically erasable programmable read-only memory (EEPROM) integrated circuit. The control unit 550 controls communication between a system on which the integrated slot 510 combined with the integrated slot connection unit 560 is mounted and a network 590 connected to the LAN card 530 by the network connection unit 580 and transmits data.

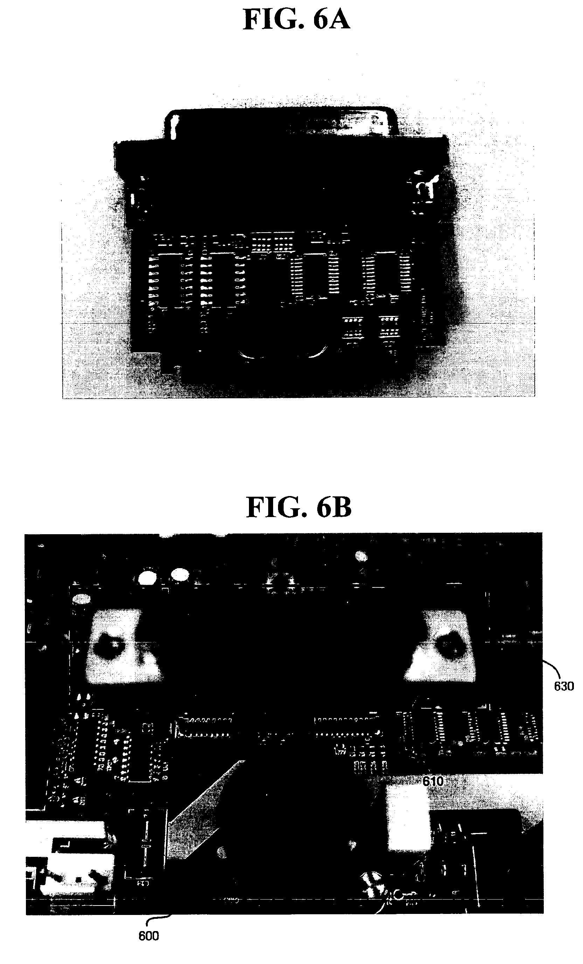

A parallel communication card for implementing a function such as software downloading can also perform its function through an integrated slot, as shown in Figures 6A and 6B.

Figure 6A illustrates a parallel communication card according to an embodiment of the present invention, and Figure 6B illustrates a printed circuit board on which an integrated slot combined with the parallel communication card is mounted according to an embodiment of the present invention. An integrated slot 610 is attached to a printed circuit board 600, and a parallel communication card 630 is combined with the printed circuit board 600 in the integrated slot 610 in a vertical direction.

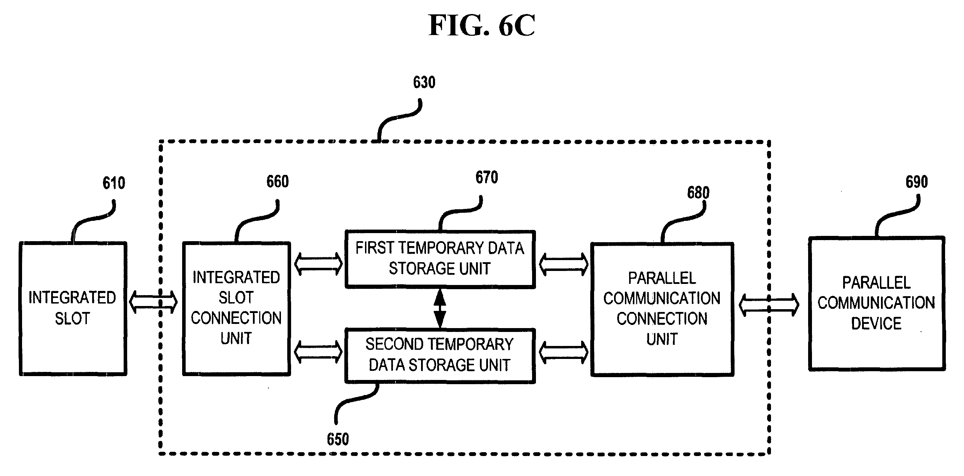

Figure 6C is a block diagram of the parallel communication card 630 of Figure 6A. The parallel communication card 630 according to an embodiment of the present invention comprises an integrated slot connection unit 660, a first temporary data storage unit 670, a second temporary data storage unit 650, and a parallel communication connection unit 680.

The integrated slot connection unit 660 is combined with the integrated slot 610 according to an embodiment of the present invention. The parallel communication connection unit 680 is connected to a parallel communication device 690 that can perform parallel communication and may be, for example, a 25-pin parallel female connector. The first temporary data storage unit 670 temporarily stores data transmitted from the parallel communication connection unit 680 and transmits the data, called first data, to the integrated slot connection unit 660. Here, the first data refers to parallel data comprising predetermined bits, and the first temporary data storage unit 670 may comprise at least one data buffer integrated circuit device. In order for the first data stored in the first temporary data storage unit 670 to be correctly transmitted to the integrated slot connection unit 660, a flow of the first data should be controlled. Herein, data required for such a control is second data and the second data is stored in the second temporary data storage unit 650.

In other words, the parallel communication connection unit 680 transmits the first data and the second data required for controlling the flow of the first data to the first temporary data storage unit 670 and the second temporary data storage unit 650, respectively. The operations of the integrated slot connection unit 660 and the first temporary data storage unit 670 are controlled by the second data stored in the second temporary data storage unit 650, thereby correctly transmitting the first data from the parallel communication device 690 to the integrated slot 610.

As described above, according to this embodiment of the present invention, by configuring a printed circuit board having an integrated slot mounted thereon, it is possible to efficiently use space on the printed circuit board and reduce the size of a system comprising the printed circuit board and the cost required for manufacturing the printed circuit board.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment (s). The invention extends to any novel one, or any novel combination, of the features disclosed in this specification (including any accompanying claims, abstract and drawings), or to any novel one, or any novel combination, of the steps of any method or process so disclosed.

## Claims

1. A printed circuit board (300,500,600) comprising a central processing unit (320) and a device controlled by the central processing unit (320), the printed circuit board (300,500,600) comprising:
an integrated slot (310,510,610) which allows a plurality of boards (350,530,630) to perform communication functions by being selectively combined with the boards and is configured such that the boards (350,570,630) are combined with the printed circuit board (300,500,600) in a vertical direction.

2. The printed circuit board of claim 1, wherein the integrated slot (310,510,610) comprises 69 communication lines for transmission of information.

3. The printed circuit board of claim 1 or 2, wherein each of the plurality of boards (330,530,630) comprises a connector for parallel transmission of data provided at its one side.

4. The printed circuit board of claim 1, 2 or 3, wherein each of the plurality of boards (330,530,630) performs network functions.

5. The printed circuit board of claim 4, wherein each of the plurality of boards (330,530,630) supports Ethernet communication .

6. The printed circuit board of claim 4, wherein each of the plurality of boards (330,530,630) supports wireless communication .

7. The printed circuit board of any of claims 1 to 6, wherein each of the plurality of boards (330,530,630) has a communication line for transmission of information mounted thereon and the mounted communication line is combined with the integrated slot (310,510,610).

8. The printed circuit board of claim 1, wherein one of the plurality of boards (330,530,630) comprises a local area network (LAN) card (530).

9. The printed circuit board of claim 1, wherein at least one of the plurality of boards (330,530,630) comprises:
a storage unit (570) for storing a medium access control (MAC) address;
a network connection unit (580) for connecting to a network (590); and
a control unit (550) for controlling communication between the at least one plurality of boards (330,530,630) and a network (590).

10. The printed circuit board of claim 9, wherein the storage unit (570) comprises:
an electrically erasable programmable read only memory (EEPROM) integrated circuit.

11. The printed circuit board of claim 9 or 10, wherein the network connection unit (580) comprises a RJ-45 jack.

12. The printed circuit board of any preceding claim, wherein at least one of the plurality of boards (330,530,630) comprises:
a first data storage unit (670) for storing a first set of data;
a second data storage unit (650) for storing a second set of data; and
a parallel communication connection unit (680) for controlling a flow of the first set of data and the second set of data.

13. The printed circuit board of claim 12, wherein the first data storage unit (670) and the second data storage unit (650) temporarily store data.

14. The printed circuit board of claim 12 or 13, wherein the first data storage unit (670) comprises at least one data buffer integrated circuit device.

15. The printed circuit board of claim 12, 13 or 14, wherein operations of the integrated slot (310,510,610) and the first data storage unit (670) are controlled by the second set of data stored in the second data storage unit (650).

16. The printed circuit board of any of claims 12 to 15, further comprising:
a parallel communication device (690) for providing parallel communication between the parallel communication unit and a network (590).

17. The printed circuit board of claim 16, wherein the parallel communication device (690) comprises a 25 pin parallel connector.

18. The printed circuit board of any preceding claim, wherein the plurality of boards (330,530,630) associated with the integrated slot (310,510,610) are mounted at an angle relative to the printed circuit board (300,500,600).
